(19) Europäisches Patentamt
European Patent Office
Office européen des brevets

(11) **EP 1 037 115 B1**

(12) **EUROPÄISCHE PATENTSCHRIFT**

(45) Veröffentlichungstag und Bekanntmachung des Hinweises auf die Patenterteilung:
**18.05.2005 Patentblatt 2005/20**

(51) Int Cl.$^7$: **G03F 7/20**, G02B 17/06

(21) Anmeldenummer: **99125700.7**

(22) Anmeldetag: **23.12.1999**

(54) **Mikrolithographie-Projektionsobjektiveinrichtung sowie Projektionsbelichtungsanlage**

Microlithographic projection objective and projection exposure apparatus

Objectif de projection microlithographique et appareil d' exposition par projection

(84) Benannte Vertragsstaaten:
**DE FR GB NL**

(30) Priorität: **11.03.1999 DE 19910724**

(43) Veröffentlichungstag der Anmeldung:
**20.09.2000 Patentblatt 2000/38**

(73) Patentinhaber: **Carl Zeiss SMT AG**
**73446 Oberkochen (DE)**

(72) Erfinder: **Dinger, Udo, Dr.**
**73447 Oberkochen (DE)**

(74) Vertreter:
**Sawodny, Michael-Wolfgang, Dr. Dipl.-Phys.**
**Adolf - Lüken - Höflich - Sawodny**
**Dreiköniggasse 10**
**89073 Ulm (DE)**

(56) Entgegenhaltungen:
**WO-A-99/26097       US-A- 5 815 310**

**Beschreibung**

Die Erfindung betrifft ein Mikrolithographieobjektiv gemäß dem Oberbegriff von Anspruch 1, eine Projektionsbelichtungsanlage gemäß Anspruch 25 sowie ein Chipherstellungsverfahren gemäß Anspruch 28.

Die Lithographie mit Wellenlängen < 193 nm, insbesondere die EUV-Lithographie mit $\lambda$ = 11 nm bzw. $\lambda$ = 13 nm werden als mögliche Techniken zur Abbildungen von Strukturen < 130 nm, besonders bevorzugt < 100 nm diskutiert. Die Auflösung eines lithographischen Systems wird durch nachfolgende Gleichung beschrieben:

$$RES = k_1 \cdot \frac{\lambda}{NA}$$

wobei k1 ein spezifischer Parameter des Lithographieprozesses, $\lambda$ die Wellenlänge des einfallenden Lichtes und NA die bildseitige, numerische Apertur des Systems bezeichnet.

Für abbildende Systeme im EUV-Bereich stehen als optische Komponenten im wesentlichen reflektive Systeme mit Multilayer-Schichten zur Verfügung. Als Multilayer-Schichtsysteme finden bei $\lambda$ = 11 nm bevorzugt Mo/Be-Systeme und bei $\lambda$ = 13 nm Mo/Si-Systeme Verwendung.

Legt man eine eine numerische Apertur von 0,15 zugrunde, so erfordert die Abbildung von 50 nm-Strukturen mit 13 nm-Strahlung einen Prozeß mit $k_1$ = 0,57. Mit $k_1$ = 0,47 wird bei 11 nm-Strahlung die Abbildung von 35 nm-Strukturen möglich.

Da die Reflektivität der eingesetzten Multilayer-Schichten nur im Bereich von ungefähr 70 % liegt, ist es bei den Projektionsobjektiven für die EUV-Mikrolithographie von ganz entscheidender Bedeutung, zum Erreichen einer ausreichenden Lichtstärke mit möglichst wenig optischen Komponenten im EUV-Projektionsobjektiv auszukommen.

Als besonders bevorzugt haben sich mit Blick auf eine hohe Lichtintensität und ausreichende Möglichkeiten zur Korrektur von Abbildungsfehlern bei NA = 0,20 Systeme mit sechs Spiegeln herausgestellt.

6-Spiegel-Systeme für die Mikrolithographie sind aus den Druckschriften US-A-5686728 und EP 0779528 bzw. US 5815310 bekannt geworden.

Das Projektions-Lithographiesystem gemäß der US-A-5686728 zeigt ein Projektionsobjektiv mit sechs Spiegeln, wobei jede der reflektiven Spiegelflächen asphärisch ausgebildet ist. Die Spiegel sind entlang einer gemeinsamen optischen Achse so angeordnet, daß ein obskurationfreier Lichtweg erreicht wird.

Da das aus der US-A-5686728 bekannte Projektionsobjektiv nur für UV-Licht mit einer Wellenlänge von 100 - 300 nm eingesetzt wird, weisen die Spiegel dieses Projektionsobjektives eine sehr hohe Asphärizität von ungefähr +/- 50 µm sowie sehr große Einfallswinkel von ca. 38° auf. Auch nach Abblenden auf NA = 0,2 verbleibt hier eine Asphärizität von 25 µm von Spitze zu Spitze bei kaum vermindertem Einfallswinkel. Derartige Asphärizitäten und Einfallwinkel sind im EUV-Bereich wegen der hohen Anforderungen an die Oberflächenqualität, Reflektivität der Spiegel nach heutigem Stand der Technik nicht praktikabel.

Ein weiterer Nachteil des aus der US-A-5686728 bekannt gewordenen Objektives, der einen Einsatz im Bereich von $\lambda$ < 100 nm, insbesondere bei den Wellenlängen von 11 und 13 nm nicht mehr erlaubt, ist der sehr geringe Abstand zwischen dem Wafer und dem dem Wafer am nächsten liegenden Spiegel. Bei den aus der US-A-5686728 bekanntgewordenen Abständen von Wafer und wäfernächstem Spiegel können die Spiegel nur sehr dünn ausgebildet werden. Wegen der extremen Schicht-Spannungen in den Multilayer-Systemen für die angesprochenen Wellenlängen von 11 und 13 nm sind derartige Spiegel sehr instabil.

Aus der EP-A-0779528 ist ein Projektionsobjektiv mit sechs Spiegeln zum Einsatz in der EUV-Lithographie, insbesondere auch bei Wellenlängen von 13 nm und 11 nm, bekanntgeworden.

Auch dieses Projektionsobjektiv hat den Nachteil, daß mindestens zwei der insgesamt sechs Spiegel sehr hohe Asphärizitäten von 26 bzw. 18,5 µm aufweisen. Insbesondere ist aber auch bei der aus der EP-A-0779528 bekannten Anordnung der optische freie Arbeitsabstand zwischen wafernächstem Spiegel und Wafer derart gering, daß es entweder zu Instabilitäten oder aber einem mechanisch freien Arbeitsabstand, der negativ ist, kommt.

Aus nachfolgenden Veröffentlichungen sind 4-Spiegel-Projektionsobjektive bekanntgeworden:

* US 5 315 629
* EP 0 480 617
* US 5 063 586
* EP 0 422 853

Die US 5 315 629 zeigt ein 4-Spiegel-Projektionsobjektiv mit NA = 0,1 sowie 4x, 31.25x0,5mm$^2$.

Aus der EP 0 480 617 B1 sind zwei NA=0.1, 5x, 25x2mm$^2$-Systeme bekanntgeworden.

Die Systeme gemäß US 5 063 586 und EP 0 422 853 weisen ein rechteckiges Bildfeld (mindestens 5x5mm$^2$) auf. Die i.a. dezentrierten Systeme sind mit sehr hohen Verzeichnungswerten im %-Bereich behaftet. Die Objektive könnten daher nur in Steppem mit Verzeichnungsvorhalt auf dem Retikel eingesetzt werden. Das hohe Niveau der Verzeichnung läßt eine solche Verwendung allerdings bei Wellenlängen < 100 nm nicht zu.

Aus der US 5 153 898 sind pauschal beliebige 3 bis 5-Multilayer-Spiegel-Systeme bekanntgeworden. Die offengelegten Realisierungen beschreiben allerdings durchweg 3-Spiegelsysteme mit Rechteckfeld und kleiner numerischer Apertur NA (NA<0.04). Die Systeme sind daher auf die Abbildung von Strukturen >=0.25μm beschränkt. Die Verzeichnung der meisten Beispiele liegt im μm-Bereich.

Betreffend den allgemeinen Stand der Technik wird desweiteren auf T. Jewell: "Optical system design issues in development of projection camera for EUV lithography", Proc SPIE 2437 (1995) und die darin angegebenen Zitate verwiesen, deren Offenbarungsgehalt vollumfänglich in die Anmeldung mit aufgenommen wird.

Aufgabe der Erfindung ist es, eine für die Lithographie mit kurzen Wellenlängen, vorzugweise kleiner 100 nm, geeignete Projektionsobjektiveinrichtung anzugeben, die die zuvor erwähnten Nachteile des Standes der Technik nicht aufweist, mit möglichst wenigen optischen Elementen auskommt und andererseits eine ausreichend große Apertur aufweist.

Erfindungsgemäß wird die Aufgabe durch eine Projektionsobjektiveinrichtung gelöst, die fünf Spiegel umfaßt.

Durch den Verzicht auf einen Spiegel ist mit dem erfindungsgemäßen 5-Spiegel-System im Vergleich zu 6-Spieglem eine um mindestens 30% höhere Transmission bei Wellenlängen im EUV-Bereich erreichbar, wenn man eine Reflektivität der Mehrfachschichtsysteme für diese Strahlung mit 70% zugrundelegt. Andererseits können Aperturen NA>0,10 realisiert werden. Das 5-Spiegel-Objektiv gemäß der Erfindung zeichnet sich somit durch hohe Auflösung, niedrige Fertigungskosten und hohen Durchsatz aus.

In einer ersten Ausführungsform der Erfindung sind bei einer numerischen Apertur $NA \geq 0,10$ und einer waferseitigen Breite des Ringfeldes $W \geq 1$ mm die Einfallswinkel AOI relativ zur Flächennormalen aller Strahlen auf allen Spiegeln durch

$$AOI \leq 22° - 2° \, (0,20 - NA) - 0,3° \, /_{mm} \, (2 \; mm - W)$$

beschränkt.

In einer bevorzugten Ausgestaltung der Erfindung ist der wafernächste Spiegel derart angeordnet ist, daß die bildseitige numerische Apertur größer gleich 0,10 ist und der bildseitige optische freie Arbeitsabstand mindestens dem genutzten Durchmesser des wafernächsten Spiegels entspricht und/oder der waferseitige optische freie Arbeitsabstand mindestens der Summe aus einem Drittel des genutzten Durchmessers dieses Spiegels und einer Länge, die zwischen 20 und 30 mm liegt, beträgt und/oder der waferseitige optische freie Arbeitsabstand mindestens 50 mm, vorzugsweise 60 mm beträgt.

In einer weiteren bevorzugten Ausgestaltung der Erfindung ist die bildseitige numerische Apertur NA größer gleich 0,10, die Ringfeldbreite W am Wafer liegt im Bereich

$$1,0 \; mm \leq W$$

und die Spitze-Spitze-Abweichung A der Asphären ist gegenüber der im Nutzbereich bestpassenden Sphäre auf allen Spiegeln durch

$$A \leq 24 \; \mu m - 129 \; \mu m (0,20 - NA) - 2, 1 \frac{\mu m}{mm} \, ( \, 2 \; mm - W)$$

beschränkt.

Besonders bevorzugt ist die Spitze-Spitze-Abweichung A der Asphären auf allen Spiegeln auf

$$A \leq 9 \; \mu m - 50 \; \mu m (0,20 - NA) - 0,4 \frac{\mu m}{mm} \, (2 \; mm - W)$$

beschränkt.

Auch Kombinationen der zuvor aufgeführten Ausfürungsformen, wie in den Ansprüchen dargestellt, zur Lösung der erfindungsgemäßen Aufgabe sind möglich; beispielsweise können in einer besonders bevorzugten Ausgestaltung alle drei Bedingungen erfüllt sein, d.h. der freie optische Arbeitsabstand mehr als 50 mm bei NA > 0,10 betragen, die Spitze-Spitze-Abweichung der Asphären sowie die Einfallswinkel im zuvor definierten Bereich liegen.

Die in dieser Schrift diskutierten Asphärizitäten beziehen sich auf die Spitze-Spitze- bzw. peak to valley (PV) -Abweichung A der asphärischen Flächen gegenüber der im Nutzbereich bestpassenden Sphäre.

Diese werden in den Beispielen durch eine Sphäre approximiert, deren Mittelpunkt auf der Figurenachse des Spiegels liegt und die im Meridionalschnitt die Ashpäre im oberen und unteren Endpunkt des Nutzbereiches schneidet.

Die Angaben zu den Einfallswinkeln beziehen sich jeweils auf den Winkel zwischen jeweiligen einfallendem Strahl und Flächennormale am Einfallsort. Angegeben ist jeweils der größte Winkel irgendeines Strahles, im allgemeinen eines bündelbegrenzenden Strahles, der an irgendeinem der Spiegel auftritt.

Unter genutztem Durchmesser sei hier und im weiteren der Hüllkreisdurchmesser des im allgemeinen nicht kreisförmigen Nutzbereiches verstanden.

Besonders bevorzugt beträgt der waferseitige optische freie Arbeitsabstand 60 mm.

Die zuvor beschriebenen Objektive können nicht nur im EUV eingesetzt werden, sondern selbstverständlich auch bei anderen Wellenlängen, ohne daß von der Erfindung abgewichen wird.

Um Degradationen der Abbildungsgüte, beispielsweise aufgrund von Mittenabschattungen zu vermeiden, ist mit Vorteil vorgesehen, daß die Spiegel des Projektionsobjektives derart angeordnet sind, daß die Lichtführung obskurationsfrei ist.

Um eine leichte Montage und Justage des Systems zu gewährleisten, ist mit Vorteil vorgesehen, daß in einer weitergebildeten Ausführungsform der Erfindung die Spiegelflächen auf zu einer Hauptachse (HA), rotationssymmetischen Fläche ausgebildet sind.

Um ein kompaktes Design des Objektives bei zugänglicher Blende zu erhalten, und einen obskurationsfreien Strahlengang zu realisieren, ist mit Vorteil vorgesehen, daß die Projektionsobjektiveinrichtung als System mit Zwischenbild ausgeführt ist. Besonders bevorzugt ist es, wenn bei einem System bestehend aus erstem und zweitem Subsystem durch das erste Subsystem mit $\beta<0$ reell in ein Zwischenbild abgebildet wird, und das zweite Subsystem das Zwischenbild in ein reelles Systembild in der Waferebene abbildet. Bei derartigen Aufbauten ist es möglich, daß die Ebene für das abzubildende Objekt sich innerhalb des Bauraumes des gesamten Spiegelsystemes umfassend ersten, zweiten, dritten, vierten und fünften Spiegel, befindet.

In einer Ausführungsform der Erfindung liegt die Blende B auf dem ersten Spiegel. In einer alternativen Ausführungsform der Erfindung ist vorgesehen, daß die frei zugängliche Blende optisch und physikalisch zwischen zweitem und drittem Spiegel liegt.

Um die nötigen Korrekturen der Abbildungsfehler in den 5-Spiegelsystemen vornehmen zu können, sind in einer bevorzugten Ausführungsform sämtliche fünf Spiegel asphärisch ausgebildet.

Eine fertigungstechnische Vereinfachung wird erreicht, wenn in einer weitergebildeten Ausführungsform vorgesehen ist, höchstens vier Spiegel asphärisch auszubilden. Es ist dann möglich, einen Spiegel, vorzugsweise den größten Spiegel sphärisch auszubilden.

Um eine Auflösung von mindestens 50 nm zu erreichen, ist mit Vorteil vorgesehen, daß der Design-Anteil des rms-Wellenfrontanteils des Systems höchstens $0,07\,\lambda$ , bevorzugt $0,03\,\lambda$ beträgt.

Vorteilhafterweise sind in den Beispielen der Erfindung die Objektive stets bildseitig telezentrisch ausgebildet.

Bei Projektionssystemen, die mit einer Reflektionsmaske betrieben werden, ist ein telezentrischer Strahlengang ohne Beleuchtung über einen stark transmissionsmindernden Strahlteiler, wie beispielsweise aus der JP-A-95 28 31 16 bekannt, objektseitig nicht möglich. Daher sind die Hauptstrahlwinkel am Retikel so gewählt, daß eine abschattungsfreie Beleuchtung gewährleistet ist.

Bei Systemen mit Transmissionsmaske kann vorgesehen sein, daß das Projektionsobjektiv objektseitig telezentrisch ausgelegt ist.

Im gesamten sollte der Telezentriefehler am Wafer 10 mrad nicht überschreiten, vorzugsweise liegt er bei 5 mrad, besonders bevorzugt bei 2 mrad. Dies stellt sicher, daß sich die Änderung des Abbildungsmaßstabes über den Tiefenschärfenbereich in tolerierbaren Grenzen hält.

In den Ausführungsformen der Erfindung ist vorgesehen, daß dieses in zwei Subsysteme unterteilt ist. Besonders bevorzugt ist das erste Subsystem ein verkleinerndes 3-Spiegel-System, vorzugsweise mit $-0,5>\beta>-1,0$ ist und das zweite Subsystem ein 2-Spiegel-System.

Neben der erfindungsgemäßen Projektionsobjektiveinrichtung stellt die Erfindung auch eine Projektionsbelichtungsanlage, umfassend mindestens eine derartige Einrichtung, zur Verfügung. In einer ersten Ausführungsform weist die Projektionsbelichtungsanlage eine Reflektionsmaske auf, in einer alternativen Ausführungsform eine Transmissionsmaske.

Besonders bevorzugt ist es, wenn die Projektionsbelichtungsanlage eine Beleuchtungseinrichtung zur Beleuchtung eines außeraxialen Ringfeldes umfaßt und das System als Ringfeldsscanner ausgebildet ist. Mit Vorteil ist vorgesehen, daß die Sekantenlänge des Scan-Schlitzes mindestens 26 mm beträgt und die Ringbreite größer als 0,5 mm ist, so daß eine homogene Beleuchtung ermöglicht wird.

Die Erfindung soll nachfolgend anhand der Zeichnungen beispielhaft beschrieben werden.

Es zeigen:

Figur 1:      ein erstes erfindungsgemäßes System mit reellem Zwischenbild zwischen erstem und zweitem Subsystem;

Figur 2: eine zweite erfindungsgemäße Ausführungsform, bei der die Blende zwischen zweitem und drittem Spiegel liegt;

Figur 3A - 3B: Definition des genutzten Durchmessers bei unterschiedlich ausgeleuchteten Lichtfeldern.

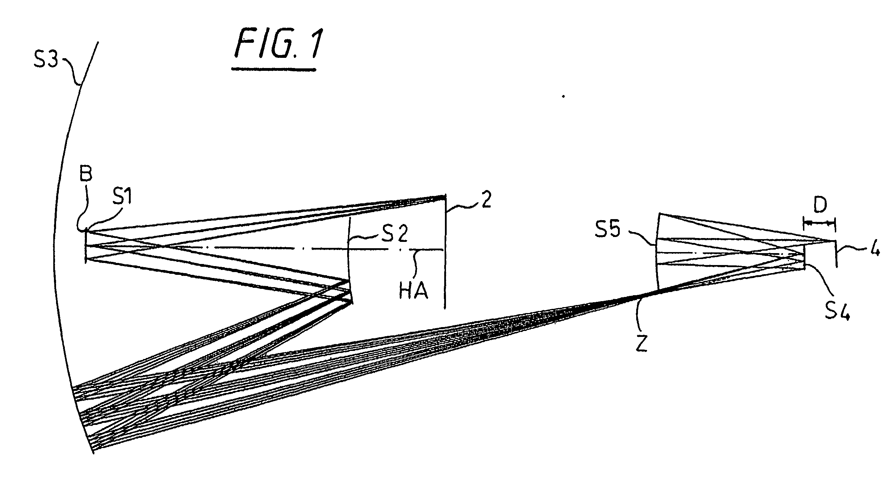

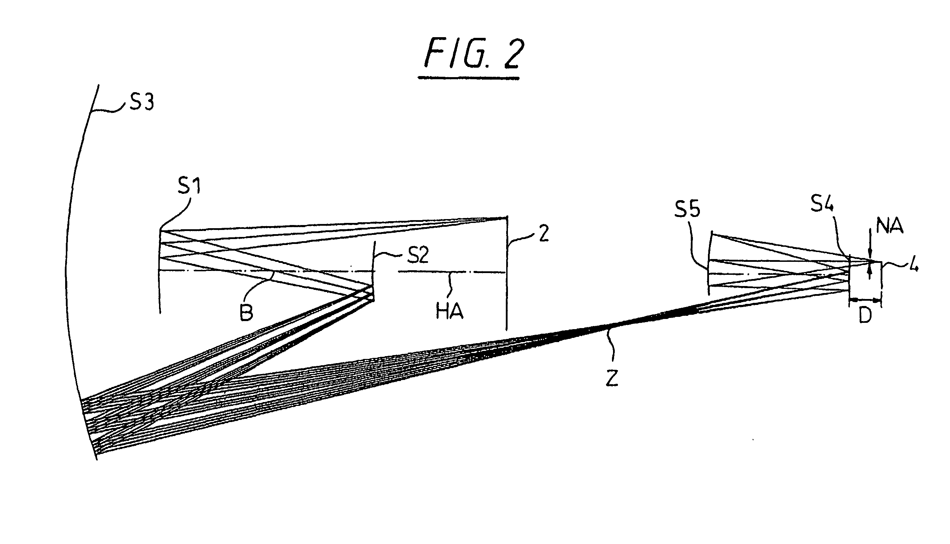

In den nachfolgenden Figuren 1 und 2 sind beispielhafte Anordnungen von erfindungsgemäßen 5-Spiegel-Projektionsobjektiven gezeigt, die einen freien optischen Arbeitsabstand, der mindestens dem genutzten Durchmesser des wafernächsten Spiegels entspricht, aufweisen.

In sämtlichen Ausführungsformen werden nachfolgend für gleiche Bauelemente gleiche Bezugsziffern verwendet, wobei nachfolgende Nomenklatur verwendet wurde:

- erster Spiegel (S1), zweiter Spiegel (S2)
- dritter Spiegel (S3), vierter Spiegel (S4)
- fünfter Spiegel (S5).

In Figur 1 ist ein 5-Spiegel-Projektionsobjektiv gemäß der Erfindung mit Strahlengang von der Retikelebene 2 bis zur Waferebene 4 dargestellt. Die dargestellte spezielle Ausgestaltung des erfindungsgemäßen Systems kann aufgefaßt werden als Hintereinanderschaltung

- eines aus S1, S2 und S3 gebildeten 3-Spiegelsystems, welches eine reelle, verkleinerte Abbildung des von S1 erzeugten virtuellen Bildes des Objektes in das System-Zwischenbild Z bewirkt und
- eines 2-Spiegelsstems S4, S5, welches das Zwischenbild Z unter Einhaltung der Telezentrieanforderungen in die Waferebene 4 abbildet.

Die Aberrationen der Subsysteme sind dabei so gegeneinander ausbalanciert, daß das Gesamtsystem eine für die Anwendung hinreichende Güte besitzt.

Die physikalische Blende B ist auf dem ersten Spiegel S1 angeordnet. Durch diese Position wird eine sehr effiziente Abschaltung von an S2 reflektiertem Licht möglich, das bei einer physikalischen Blendenposition zwischen S1 und S2 leicht oberhalb der als schmalen Ring auszubildenden Blende passieren könnte. Bei dem in Figur 1 dargestellten Ausführungsbeispiel kann die Blende entweder als Öffnung im S1-Mutterspiegel oder hinter S1 liegend realisiert werden.

Beim System gemäß Figur 1 ist der optische Arbeitsabstand D zwischen dem wafernächsten Spiegel - in vorliegendem Ausführungsbeispiel der vierte Spiegel S4 - und der Waferebene 4 größer als der genutzte Durchmesser des Spiegels S4, d.h. es ist nachfolgende Bedingung erfüllt:

optischer Abstand S4 zur Waferebene 4 > genutzter Durchmesser S4.

Auch andere Abstandsbedinungen sind alternativ möglich, beispielsweise daß der optische Arbeitsabstand größer als die Summe aus ein Drittel des genutzten Durchmessers des wafernächsten Spiegels S4 plus 20 mm oder mehr als 50 mm ist.

Im vorliegenden Ausführungsbeispiel beträgt der freie optische Arbeitsabstand 60 mm, ohne hierauf beschränkt zu sein.

Ein derartiger optischer Arbeitsabstand garantiert einen ausreichend freien mechanischen Arbeitsabstand, der größer als 0 ist sowie die Verwendung von optischen Komponenten mit ausreichenden Festigkeitseigenschaften für Wellenlängen < 100 nm, vorzugsweise von 11 bzw. 13 nm.

Die optischen Komponenten umfassen für eine Wellenlänge $\lambda$ = 13 nm und $\lambda$ = 11 nm beispielsweise Mo/Si- bzw. Mo/Be-Multilayer-Schichtsysteme, wobei typische Multilayer-Schichtsysteme für $\lambda$ = 13 nm 40 Mo/Si-Schichtpaare und für $\lambda$ = 11 nm taugliche Mo/Be-Systeme ungefähr 70 Schichtpaare aufweisen. Die erreichbaren Reflektivitäten der Systeme liegen im Bereich von ungefähr 70 %. In den Multilayer-Schichtsystemen können Schichtspannungen von 350 MPa und mehr auftreten, die Oberflächendeformation, insbesondere in den Randbereichen der Spiegel induzieren.

Die erfindungsgemäßen Systeme, wie beispielsweise in Figur 1 dargestellt, besitzen gemäß

$$RES = \frac{k1\lambda}{NA}$$

eine nominelle Auflösung von mindestens 50 nm bzw. 35 nm bei einer minimalen numerischen Apertur von NA = 0,15

bei $k_1$ = 0,57 und $\lambda$ = 13 nm bzw. $k_1$ = 0,47 und $\lambda$ = 11 nm, wobei $k_1$ ein Lithographieprozeß-spezifischer Parameter ist.

Des weiteren ist der Strahlengang des in Fig. 1 dargestellten Objektives obskurationsfrei. Um beispielsweise Bildformate von beispielsweise 26 x 34 mm$^2$ bzw. 26 x 52 mm$^2$ bereitzustellen, werden die erfindungsgemäßen Projektionsobjektive vorzugsweise in Ringfeld-Scan-Projektionsbelichtungsanlagen verwendet, wobei die Sekantenlänge des Scan-Schlitzes mindestens 26 mm beträgt.

Je nach verwandter Maske in der Projektionsbelichtungsanlage, hier sind Transmissionsmasken z.B. Stencilmasken oder auch Reflektionsmasken denkbar, kann das bildseitig telezentrische System objektseitig telezentrisch oder nicht telezentrisch ausgebildet werden, wobei ein telezentrischer Strahlengang objektseitig bei Verwendung einer Reflektionsmakse nur unter Verwendung eines transmissionsmindernden Strahlenteilers möglich ist. Unebenheiten der Maske führen bei nicht telezentrischem Strahlengang im Objektraum zu Maßstabsfehlem in der Abbildung. Die Hauptstrahlwinkel am Retikel liegen daher vorzugsweise unter 10°, damit die Anforderungen an die Retikelebenheit im Bereich des technologisch realisierbaren liegen.

Das erfindungsgemäße System gemäß Figur 1 weist einen bildseitigen Telezentriefehler am Wafer von 3 ± 0.1 mrad bei einer numerischen Apertur von 0,15 auf.

In der dargestellten Ausführungsform sind sämtliche Spiegel S1 - S5 asphärisch ausgeführt, wobei die maximale Asphärizität im Nutzbereich bei 14 µm liegt. Die maximale Asphärizität tritt am Spiegel S3 auf. Die insgesamt niedrige Asphärizität der erfindungsgemäßen Anordnung ist insbesondere aus fertigungstechnischer Sicht vorteilhaft, da die technologischen Schwierigkeiten bei der Bearbeitung der Oberflächen der Multilayer-Spiegel mit der asphärischen Abweichung und wachsendem Gradienten der Asphäre überproportional stark ansteigen.

Der größte Einfallswinkel in der Anordnung gemäß Figur 1 tritt an S2 auf und beträgt 18,9°. Der Wellenfrontfehler der Anordnung gemäß Figur 1 bei $\lambda$ = 13 nm ist besser als 0,023 $\lambda$ im 2 mm breiten Ringfeld.

Ein Vorteil der in Fig. 1 und 2 gezeigten Ausführungsformen ist, daß der Nachteil eines Spiegelsystems mit ungerader Spiegelanzahl, nämlich daß sich ein gestreckter Aufbau Retikel-Projektionsoptik- Wafer nicht mehr realisieren läßt, überwunden wird. Dieser Nachteil resultierte aus der Tatsache, daß Retikel- und Waferebene bei near normal incidence Systemen aus der gleichen Vorzugsrichtung beleuchtet werden, was dazu führt, daß entweder beide auf der gleichen Seite des Objektives, oder wenigstens eine der beiden Ebenen innerhalb des Objektives zu liegen kommt.

Gemäß der Ausführungsform nach Figur 1 oder 2 wird die Retikelebene 2 innerhalb des Projektionssystems plaziert. Die Spiegelanordnung wird so gewählt, daß in Richtung der optischen Achse ein möglichst großer Bauraum - in einem bevorzugten Ausführungsbeispiel 400 mm - für die Retikelstage vorgesehen ist. Außerdem wird im Objektraum in der Meridionalebene ein hinreichend großer Abstand zwischen Objektfeld und vorbeilaufenden Lichtbüscheln sichergestellt, so daß im Ringfeld-Scanning-Betrieb ein hinreichend großes Bildfeld abgescannt werden kann. In einem bevorzugten Ausführungsbeispiel können ca. 200 mm auf dem Retikel entsprechend 50 mm auf dem Wafer gescannt werden.

In der in Fig. 1 gezeigten Ausführungsform hat das 2-Spiegel-Subsystem (S4,S5) vor dem Wafer innerhalb weniger Prozent gleiche Radien R, der Abstand der beiden oblaten Ellipsiodspiegel entspricht ungefähr R/√2. Das retikelnahe 3-Spiegel-Subsystem besteht aus drei nahezu konzentrischen Spiegeln (S1,S2,S3), wovon Primär- (S1) und Tertiärspiegel (S3) ähnliche Radien aufweisen. Von einem gestörten Offnersystem unterscheidet sich das retikelnahe Subsystem hauptsächlich durch die Blendenlage auf dem Primärspiegel und den nichttelezentrischen Strahlengang am Retikel.

Zwischen den beiden Subsystemen entsteht ein reelles Zwischenbild Z. Die Hauptstrahlwinkelneigung auf dem Retikel erlaubt die abschattungsfreie Beleuchtung einer Reflexionsmaske.

Des weiteren sind bei der Ausführungsform der Erfindung gemäß den Figuren 1 und 2 die Abstände zwischen den Spiegeln so groß gewählt, daß die Spiegel hinreichend dick ausgebildet werden können, um bei den auftretenden hohen Schichtspannungen über die geforderten Festigkeitseigenschaften zu verfügen.

Aus der nachfolgenden Tabelle gehen in Code V-Nomenklatur die Parameter der beispielhaft in Figur 1 dargestellten Systeme hervor. Bei dem Objektiv handelt es sich um 4x-System mit einem 26 x 2 mm$^2$ Ringfeld und einer numerischen Apertur NA von 0,15. Der mittlere bildseitige Radius des Systems beträgt dabei ungefähr 26 mm.

## Tabelle 1:

| Element Nummer | | Radius | Dicke | Durchmesser | Art |
|---|---|---|---|---|---|
| Objekt | | INF | -693.4069 | | |
| | | | 354.7680 | 52.0652 | |
| | | | -92.4573 | 135.9392 | |
| | | | -262.3106 | 114.0805 | |
| | | | Aperturblende | 52.0652 | |
| 1 | | A(1) | 0.0000 | | |
| | | | 354.7680 | 52.1468 | REFL |
| | | | 148.5214 | 150.4663 | |
| 2 | | A(2) | 0.0000 | 191.7567 | |
| | | | -148.5214 | 194.3744 | REFL |
| | | | -415.5887 | 375.2582 | |
| 3 | | A(3) | 564.2101 | 763.1343 | REFL |
| | | | 590.1176 | 488.5602 | |
| | | | 276.5162 | 161.9611 | |
| 4 | | A(4) | -276.5162 | 56.7269 | REFL |
| 5 | | A(5) | 276.5162 | 150.9852 | REFL |
| Bild | Bildweite | | 59.0000 | 71.4698 | |
| | | | | 54.0239 | |

Asphärische Konstanten:

$$Z = \frac{(CURV)\,Y^2}{1 + (1-(1+K)\,(CURV)^2\,Y^2)^{1/2}} + (A)\,Y^4 + (B)\,Y^6 + (C)\,Y^8 + (D)\,Y^{10}$$

| Asphäre | CURV | K | A | B | C | D |
|---|---|---|---|---|---|---|
| A( 1) | 0.00101481 | 5.819224 | 0.00000E+00 | 3.87962E-14 | 4.75060E-18 | -3.72457E-22 |
| A( 2) | 0.00199897 | -1.309152 | 0.00000E+00 | 2.41371E-15 | 1.13811E-19 | -4.72546E-24 |
| A( 3) | 0.00101913 | -0.052382 | 0.00000E+00 | -4.60125E-18 | 2.36912E-23 | -4.12881E-29 |
| A( 4) | 0.00276967 | 9.374573 | 0.00000E+00 | -3.75169E-13 | 2.32666E-17 | -7.34639E-21 |
| A( 5) | 0.00276492 | 0.075719 | 0.00000E+00 | 2.43566E-17 | -1.36024E-20 | 1.02566E-25 |

Referenz Wellenlänge = 13 nm

In Figur 2 ist eine alternative Ausführungsform eines erfindungsgemäßen 5-Spiegelsystems dargestellt, bei dem die Blende B zwischen dem ersten Spiegel und dem dritten Spiegel liegt. Gleiche Bauteile wie in Figur 1 werden wiederum mit denselben Bezugsziffern belegt.

Der optisch freie Arbeitsabstand am Wafer beträgt auch bei dieser Ausführungsform wie schon bei der Ausführungsform gemäß Figur 1 ungefähr 60 mm und ist somit größer als der Durchmesser des wafernächsten Spiegels S4.

Im Unterschied zu der Ausgestaltung gemäß Figur 1 ist in Figur 2 die Blende B physikalisch zwischen erstem und zweitem Spiegel frei zugänglich gelegt.

Der Wellenfrontfehler der Anordnung gemäß Figur 2 beträgt 0,024 $\lambda$, innerhalb des 1,7 mm breiten Ringfeldes bei $\lambda = 13$ nm.

In Tabelle 2 sind die Konstruktionsdaten des 4x Objektives gemäß Figur 2 in Code V-Nomenklatur dargestellt. Der mittlere Radius des 26 x 1,7 mm$^2$-Bildfeldes beträgt wiederum 26 mm; die Apertur NA = 0,15.

## Tabelle 2:

| Element Nummer | Radius | Dicke | Durchmesser | Art |
|---|---|---|---|---|
| Objekt | INF | 4693.4069 | | |
| | | 354.7545 | 154.7165 | |
| | | -92.4523 | 186.3707 | |
| | | -262.3122 | 177.8997 | |
| | | - 0.0000 | 154.7165 | |
| 1 | A(1) | 236.0296 | 155.0648 | REFL |
| | | 0.0000 Aperturblende | 37.8314 | |
| | | 184.2473 | 37.8314 | |
| 2 | A(2) | -168.2690 | 108.2091 | REFL |
| | | -435.4421 | 290.4780 | |
| 3 | A(3) | 503.7111 | 685.3013 | REFL |
| | | 673.5394 | 431.6713 | |
| | | 275.3310 | 148.3568 | |
| 4 | A(4) | -275.3310 | 51.3839 | REFL |
| 5 | A(5) | 275.3310 | 153.1971 | REFL |
| | | 63.1295 | 72.9358 | |
| Bild | Bildweite | | 54.0638 | |

### Asphärische Konstanten:

$$Z = \frac{(CURV)\,Y^2}{1+(1-(1+K)\,(CURV)^2\,Y^2)^{1/2}} + (A)\,Y^4 + (B)\,Y^6 + (C)\,Y^8 + (D)\,Y^{10}$$

| Asphäre | CURV | K | A | B | C | D |
|---|---|---|---|---|---|---|
| A( 1) | 0.00130712 | 0.130035 | 0.00000E-00 | 1.65206E-15 | -1.65350E-19 | 8.14629E-23 |
| A( 2) | 0.00277574 | 0.391769 | 0.00000E+00 | -7.44252E-14 | 2.28766E-17 | -2.87177E-21 |
| A( 3) | 0.00102490 | -0.014023 | 0.00000E+00 | -2.96927E-17 | 1.64882E-22 | -3.87455E-23 |
| A( 4) | 0.00210508 | 12.751039 | 0.00000E-00 | -8.13887E-14 | -1.07272E-15 | 3.55319E-20 |
| A( 5) | 0.00262203 | 0.142491 | 0.00000E-00 | 3.75138E-17 | 1.36791E-20 | -3.22349E-21 |

Referenz Wellenlänge = 13 nm

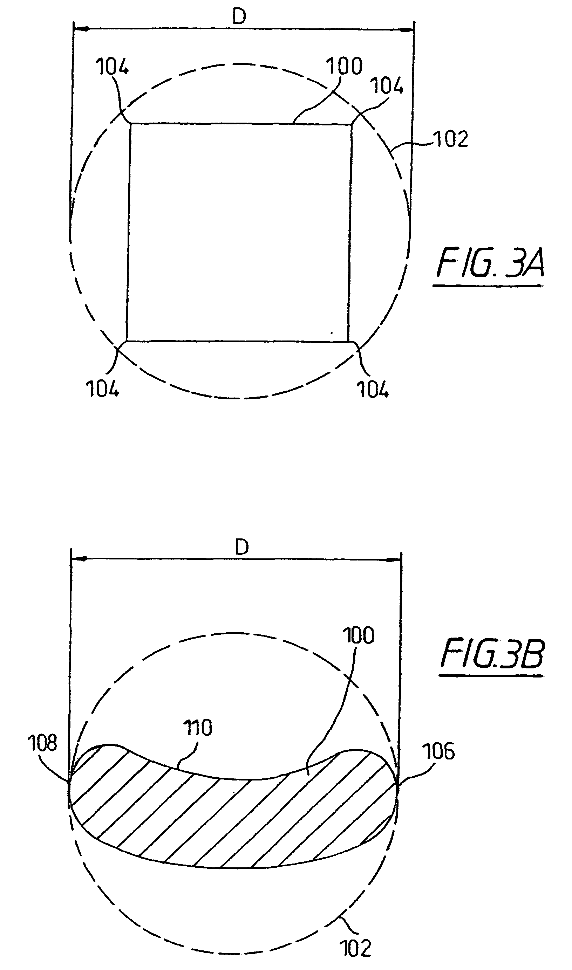

Die Fig. 3A und 3B verdeutlichen nochmals was in der vorliegenden Anmeldung unter dem genutzten Durchmesser D zu verstehen ist.

Beispielhaft sei das ausgeleuchtete Feld 100 auf einem Spiegel in Figur 3A ein Rechteckfeld. Der genutzte Durchmesser D ist dann der Durchmesser des Hüllkreises 102, der das Rechteck 100 umschließt, wobei die Ecken 104 des Rechteckes 100 auf den Hüllkreis 102 zu liegen kommen.

In Figur 3B ist ein zweites Beispiel dargestellt. Das ausgeleuchtete Feld 100 weist eine Nierenform auf, wie für den Nutzbereich bei Verwendung der erfindungsgemäßen Objektive in einer Mikrolithographie-Projektionsbelichtungsanlage erwartet. Der Hüllkreis 102 umschließt die Nierenform völlig und fällt an zwei Punkten 106, 108 mit dem Rand 110 der Nierenform zusammen. Der genutzte Durchmesser D ergibt sich dann aus dem Durchmesser des Hüllkreises 102.

Mit der Erfindung wird somit erstmals ein 5-Spiegel-Projektionsobjektiv mit einem Abbildungsmaßstab von vorzugsweise 4x, 5x sowie 6x für den bevorzugten Einsatz in einem EUV-Ringfeldprojektionssystem angegeben, das sowohl die notwendige Auflösung bei gefordertem Bildfeld wie auch Konstruktionsbedingungen aufweist, welche eine funktionsgerechte Bauausführung ermöglichen, da die Asphären hinreichend mild, die Winkel hinreichend klein für die Schichten und die Bauräume für die Spiegelträger hinreichend groß sind.

**Patentansprüche**

1. Mikrolithographie-Projektionsobjektiveinrichtung für kurze Wellenlängen, vorzugsweise < 100 nm mit einem ersten (S1), einem zweiten Spiegel (S2), einem dritten Spiegel (S3), einem vierten Spiegel (S4) sowie einem fünften Spiegel (S5) mit Ringfeld, **dadurch gekennzeichnet, daß** die bildseitige numerische Apertur NA $\geq$ 0,10 ist, die bildseitige Breite des Ringfeldes W $\geq$ 1,0 mm ist und daß die Einfallswinkel (AOI) relativ zur Flächennormalen aller Strahlen auf allen Spiegeln durch

$$AOI \leq 22° - 2°(0,20 - NA) - 0,3° \Big/_{mm} (2mm - W)$$

beschränkt sind.

2. Mikrotithographie-Projektionsobjektiveinrichtung gemäß Anspruch 1, **dadurch gekennzeichnet, daß** das Objekt durch das aus erstem, zweitem und drittem Spiegel (S1, S2, S3) gebildete erste Subsystem mit $\beta$ < 0 reell in ein Zwischenbild (Z) abgebildet wird, wobei das aus viertem und fünftem Spiegel (S4, S5) gebildete zweite Subsystem das Zwischenbild in ein reelles Systembild in der Waferebene abbildet.

3. Mikrolithographie-Projektionsobjektiveinrichtung nach Anspruch 2, **dadurch gekennzeichnet, daß** die bildseitige numerische Apertur NA $\geq$ 0,10 ist und die Spiegel derart angeordnet sind, daß die Ebene für das abzubildende Objekt sich innerhalb des Bauraumes des Spiegelsystemes aus erstem, zweitem, drittem, viertem und fünftem Spiegel befindet.

4. Mikrolithographie-Projektionsobjektiveinrichtung gemäß Anspruch 3, **dadurch gekennzeichnet, daß** die Ebene des abzubildenden Objektes die Retikelebene ist.

5. Mikrolithographie-Projektionsobjektiveinrichtung gemäß Anspruch 4, **dadurch gekennzeichnet, daß** die Spiegel derart angeordnet sind, daß im Bereich der Retikelebene ausreichender lateraler Bauraum für einen Scan des Retikels vorgesehen ist, so daß ein obskurationsfreier Strahlengang erreicht wird.

6. Mikrolithographie-Projektionsobjektiveinrichtung gemäß Anspruch 3 oder 4, **dadurch gekennzeichnet, daß** die Spiegel derart angeordnet sind, daß im Bereich der Retikelebene ausreichender axialer Bauraum für die Retikelstage vorgesehen ist, so daß ein obskurationsfreier Strahlengang erreicht wird.

7. Mikrolithographie-Projektionsobjektiveinrichtung gemäß einem der Ansprüche 1 bis 6, **dadurch gekennzeichnet, daß** die Spiegel des zweiten Subsystems im wesentlichen gleiche Radien R aufweisen.

8. Mikrolithographie-Projektionsobjektiveinrichtung gemäß Anspruch 7, **dadurch gekennzeichnet, daß** der Abstand der beiden Spiegel des zweiten Subsystems ungefähr $R / \sqrt{2}$ beträgt.

9. Mikrolithographie-Projektionsobjektiveinrichtung gemäß einem der Ansprüche 2 bis 8, **dadurch gekennzeichnet, daß** das erste Subsystem objekt- bzw. retikelnah angeordnet ist.

10. Mikrolithographie-Projektionsobjektiveinrichtung gemäß Anspruch 9, **dadurch gekennzeichnet, daß** erster (S1) und dritter Spiegel (S3) des ersten Subsystems im wesentlichen gleiche Radien aufweisen.

11. Mikrolithographie-Projektionsobjektiveinrichtung gemäß einem der Ansprüche 1 bis 10, **dadurch gekennzeichnet, daß** der dem zu belichtenden Objekt vorzugsweise dem Wafer am nächsten kommenden Spiegel derart angeordnet ist, daß

- der bildseitige optische freie Arbeitsabstand mindestens dem genutzten Durchmesser D dieses wäfemächsten Spiegels entspricht und/oder
- der bildseitige optische freie Arbeitsabstand mindestens der Summe aus einem Drittel des genutzten Durchmessers D dieses Spiegels und einer Länge, die zwischen 20 mm und 30 mm liegt, beträgt und/oder
- der bildseitige optisch freie Arbeitsabstand mindestens 50 mm, vorzugsweise 60 mm beträgt.

12. Mikrolithographie-Projektionsobjektiveinrichtung gemäß einem der Ansprüche 1 bis 11, **dadurch gekennzeichnet, daß** die bildseitige numerische Apertur NA im Bereich

$$NA \geq 0{,}10$$

und die Ringfeldbreite W am Wafer im Bereich

$$W \geq 1{,}0 \text{ mm}$$

und daß die Spitze-Spitze-Abweichung (A) der Asphären gegenüber der im Nutzbereich bestpassenden Sphäre auf allen Spiegeln durch

$$A \leq 24\ \mu m - 129\ \mu m\ (0{,}20 - NA) - 2{,}1\frac{\mu m}{mm}\ (2mm - W)$$

beschränkt ist.

13. Mikrolithographie-Projektionsobjektiveinrichtung nach einem der Ansprüche 1 bis 12, **dadurch gekennzeichnet, daß** die Spiegelflächen auf zu einer Hauptachse (HA) rotationssymmetrischen Flächen angeordnet sind.

14. Mikrolithographie-Projektionsobjektiveinrichtung nach einem der Ansprüche 1 bis 12, **dadurch gekennzeichnet, daß** die Blende (B) im Strahlengang zwischen zweitem (S2) und drittem Spiegel (S3) am Körper des ersten Spiegels (S1) angeordnet ist.

15. Mikrolithographie-Projektionsobjektiveinrichtung nach Anspruch 14, **dadurch gekennzeichnet, daß** die Blende frei zugänglich zwischen zweitem und drittem Spiegel liegt.

16. Mikrolithographie-Projektionsobjektiveinrichtung nach einem der Ansprüche 1 bis 15, **dadurch gekennzeichnet, daß** die bildseitige numerische Apertur NA $\geq$ 0,10 und die Ringfeldbreite am Wafer W $\geq$ 1 mm ist und daß die Spitze-Spitze-Abweichung (A) der Asphären gegenüber der im Nutzbereich bestpassenden Sphären auf allen Spiegeln durch

$$A \leq 9\ \mu m - 50\ \mu m\ (0{,}20 - NA) - 0{,}4\ \frac{\mu m}{mm}\ (2mm - W)$$

beschränkt ist.

17. Mikrolithographie-Projektionsobjektiveinrichtung gemäß einem der Ansprüche 14 bis 16, **dadurch gekennzeichnet, daß** mindestens vier Spiegel asphärisch sind.

18. Mikrolithographie-Projektionsobjektiveinrichtung nach Anspruch 17, **dadurch gekennzeichnet, daß** sämtliche Spiegel asphärisch ausgebildet sind.

19. Mikrolithographie-Projektionsobjektiveinrichtung gemäß einem der Ansprüche 1 bis 18, **dadurch gekennzeichnet, daß** der Abbildungsmaßstab des aus erstem (S1), zweitem (S2) und drittem (S3) Spiegel gebildeten ersten Subsystems negativ und verkleinernd ist, vorzugsweise - 0,5 > β > - 1,0.

20. Mikrolithographie-Projektionsobjektiveinrichtung nach einem der Ansprüche 1 bis 19, **dadurch gekennzeichnet, daß** der rms-Wellenfrontfehler des Systems höchstens 0,07 λ , bevorzugt 0,03 λ , über das gesamte Bildfeld beträgt.

21. Mikrolithographie-Projektionsobjektiveinrichtung gemäß Anspruch 20, **dadurch gekennzeichnet, daß** das Bildfeld mindestens 1,0 mm breit ist.

22. Mikrolithographie-Projektionsobjektiveinrichtung nach einem der Ansprüche 1 bis 21, **dadurch gekennzeichnet, daß** sie bildseitig telezentrisch ist.

23. Mikrolithographie-Projektionsobjektiveinrichtung nach Anspruch 22, **dadurch gekennzeichnet, daß** sie objektseitig telezentrisch ist.

24. Mikrolithographie-Projektionsobjektiveinrichtung nach einem der Ansprüche 1 bis 22, **dadurch gekennzeichnet, daß** der Hauptstrahl am Objekt zur optischen Achse hinläuft.

25. Projektionsbelichtungsanlage mit einer Mikrolithographie-Projektionsobjektiveinrichtung nach einem der Ansprüche 1 bis 24, **dadurch gekennzeichnet, daß** eine Reflektionsmaske vorgesehen ist.

26. Projektionsbelichtungsanlage mit einer Mikrolithographie-Projektionsobjektiveinrichtung gemäß einem der Ansprüche 1 bis 24, **dadurch gekennzeichnet, daß** eine Transmissionsmaske vorgesehen ist.

27. Projektionsbelichtungsanlage nach einem der Ansprüche 25 bis 26, **dadurch gekennzeichnet, daß** die Projektionsbelichtungsanlage eine Beleuchtungseinrichtung zur Beleuchtung eines Ringfeldes umfaßt.

28. Verfahren zur Chipherstellung mit einer Projektionsbelichtungsanlage gemäß einem der Ansprüche 25 bis 27.

**Claims**

1. Microlithography projection lens device for short wavelengths, preferably < 100 nm, with a first (S1), a second mirror (S2), a third mirror (S3), a fourth mirror (S4) and a fifth mirror (S5) with a circular field, **characterised in that** the image-side numerical aperture NA is ≥ 0.10,
   the image-side width of the circular field W is ≥ 1.0 mm and
   **in that** the angles of incidence (AOI) relative to the surface normals of all rays on all mirrors are limited by

$$AOI \leq 22° - 2°(0.20 - NA) - 0.3°/mm \ (2mm - W)$$

2. Microlithography projection lens device according to Claim 1,
   **characterised in that** the object is projected purely real in an intermediate image (Z) by the first subsystem with β < 0 made up of the first, second and third mirror (S1, S2, S3), the second subsystem made up of the fourth and fifth mirror (S4, S5) projecting the intermediate image in a purely real system image in the wafer plane.

3. Microlithography projection lens device according to Claim 2,
   **characterised in that** the image-side numerical aperture NA is ≥ 0.10 and the mirrors are so arranged that the plane for the object to be projected is within the construction space of the mirror system consisting of the first, second, third, fourth and fifth mirror.

**4.** Microlithography projection lens device according to Claim 3,
**characterised in that** the plane of the object to be projected is the reticle plane.

**5.** Microlithography projection lens device according to Claim 4,
**characterised in that** the mirrors are so arranged that adequate lateral construction space for a scan of the reticle is provided in the region of the reticle plane, so that an obscuration-free optical path is achieved.

**6.** Microlithography projection lens device according to Claim 3 or 4,
**characterised in that** the mirrors are so arranged that adequate axial construction space for the reticle stage is provided in the region of the reticle plane, so that an obscuration-free optical path is achieved.

**7.** Microlithography projection lens device according to one of Claims 1 to 6,
**characterised in that** the mirrors of the second subsystem have essentially identical radii R.

**8.** Microlithography projection lens device according to Claim 7,
**characterised in that** the distance between the two mirrors of the second subsystem is approximately $R/\sqrt{2}$.

**9.** Microlithography projection lens device according to one of Claims 2 to 8,
**characterised in that** the first subsystem is arranged close to the object or close to the reticle.

**10.** Microlithography projection lens device according to Claim 9,
**characterised in that** the first (S1) and third mirror (S3) of the first subsystem have essentially identical radii.

**11.** Microlithography projection lens device according to one of Claims 1 to 10,
**characterised in that** the mirror that comes closest to the object to be illuminated, preferably to the wafer, is so arranged that

- the optical free working distance on the image side at least corresponds to the diameter D used for this mirror closest to the wafer and/or
- the optical free working distance on the image side is at least the sum of one third of the diameter D used for this mirror and a length that is between 20 mm and 30 mm and/or
- the optical free working distance on the image side is at least 50 mm, preferably 60 mm.

**12.** Microlithography projection lens device according to one of Claims 1 to 11,
**characterised in that** the image-side numerical aperture NA is in the range

$$NA \geq 0.10$$

and the circular field width W at the wafer is in the range

$$W \geq 1.0 \text{ mm}$$

and **in that** the peak-to-peak deviation (A) of the aspheres compared with the best-fitting sphere in the useful range on all mirrors is limited by

$$A \leq 24\ \mu m - 129\ \mu m(0.20 - NA) - 2.1\frac{\mu m}{mm}\ (2mm - W)$$

**13.** Microlithography projection lens device according to one of Claims 1 to 12,
**characterised in that** the mirror surfaces are arranged on surfaces that are rotationally symmetrical with respect to a main axis (HA).

**14.** Microlithography projection lens device according to one of Claims 1 to 12,
**characterised in that** the diaphragm (B) is arranged in the optical path between the second (S2) and third mirror (S3) on the body of the first mirror (S1).

**15.** Microlithography projection lens device according to Claim 14,
**characterised in that** the diaphragm is located between the second and third mirror such that it is freely accessible.

**16.** Microlithography projection lens device according to one of Claims 1 to 15,
**characterised in that** the image-side numerical aperture NA is ≥ 0.10 and the circular field width at the wafer W is ≥ 1 mm and **in that** the peak-to-peak deviation (A) of the aspheres compared with the best-fitting spheres in the useful range on all mirrors is restricted by

$$A \leq 9 \ \mu m - 50 \ \mu m (0.20 - NA) - 0.4 \frac{\mu m}{mm} \ (2 \ mm - W)$$

**17.** Microlithography projection lens device according to one of Claims 14 to 16, **characterised in that** at least four mirrors are aspherical.

**18.** Microlithography projection lens device according to Claim 17, **characterised in that** all mirrors are made aspherical.

**19.** Microlithography projection lens device according to one of Claims 1 to 18,
**characterised in that** the linear magnification of the first subsystem made up of the first (S1), second (S2) and third (S3) mirror is negative and reducing, preferably -0.5 > β > -1.0.

**20.** Microlithography projection lens device according to one of Claims 1 to 19,
**characterised in that** the rms wave-front error of the system is at most 0.07 λ, preferably 0.03 λ, over the entire image field.

**21.** Microlithography projection lens device according to Claim 20, **characterised in that** the image field is at least 1.0 mm wide.

**22.** Microlithography projection lens device according to one of Claims 1 to 21, **characterised in that** it is telecentric on the image side.

**23.** Microlithography projection lens device according to Claim 22, **characterised in that** it is telecentric on the object side.

**24.** Microlithography projection lens device according to one of Claims 1 to 22,
**characterised in that** the main beam at the object runs towards the optical axis.

**25.** Projection exposure unit with a microlithography projection lens device according to one of Claims 1 to 24, **characterised in that** a rejection mask is provided.

**26.** Projection exposure unit with a microlithography projection lens device according to one of Claims 1 to 24, **characterised in that** a transmission mask is provided.

**27.** Projection exposure unit according to one of Claims 25 to 26,
**characterised in that** the projection exposure unit has an illumination system for illuminating a circular field.

**28.** Process for chip manufacture using a projection exposure unit according to one of Claims 25 to 27.

**Revendications**

**1.** Dispositif à objectifs de projection microlithographique pour de faibles longueurs d'ondes, de préférence < 100 nm, comprenant un premier miroir (S1), un deuxième miroir (S2), un troisième miroir (S3), un quatrième miroir (S4), ainsi qu'un cinquième miroir (S5) à champ annulaire, **caractérisé en ce que**
l'ouverture numérique NA située côté image est ≥ 0,10,
la largeur W du champ annulaire, située côté image, est ≥ 1,0 mm ; et
**en ce que** les angles d'incidence (AOI), par rapport aux perpendiculaires aux surfaces, de tous les rayons sur tous les miroirs, sont limités par

$$AOI \leq 22° - 2° \, (0{,}20 - NA) - 0{,}3°/_{mm}(2 \, mm - W).$$

**2.** Dispositif à objectifs de projection microlithographique selon la revendication 1, **caractérisé en ce que** l'objet est reproduit en mode réel en une image intermédiaire (Z), par l'intermédiaire du premier sous-système formé des premier, deuxième et troisième miroirs (S1, S2, S3) et dans lequel β < 0, le second sous-système, formé des quatrième et cinquième miroirs (S4, S5), reproduisant l'image intermédiaire en une image réelle de système dans le plan de la plaquette.

**3.** Dispositif à objectifs de projection microlithographique selon la revendication 2, **caractérisé en ce que** l'ouverture numérique NA située côté image est ≥ 0,10, et les miroirs sont agencés de façon telle que le plan, destiné à l'objet à reproduire, se trouve à l'intérieur de l'espace structurel du système à miroirs comprenant les premier, deuxième, troisième, quatrième et cinquième miroirs.

**4.** Dispositif à objectifs de projection microlithographique selon la revendication 3, **caractérisé en ce que** le plan de l'objet à reproduire est le plan réticulaire.

**5.** Dispositif à objectifs de projection microlithographique selon la revendication 4, **caractérisé en ce que** les miroirs sont agencés de façon telle qu'un espace structurel latéral suffisant soit prévu, dans la région du plan réticulaire, pour un balayage du réticule, ce qui permet d'obtenir une trajectoire des rayons exempte d'obscurcissement.

**6.** Dispositif à objectifs de projection microlithographique selon la revendication 3 ou 4, **caractérisé en ce que** les miroirs sont agencés de façon telle qu'un espace structurel axial suffisant soit prévu, dans la région du plan réticulaire, pour l'étage réticulaire, ce qui permet d'obtenir une trajectoire des rayons exempte d'obscurcissement.

**7.** Dispositif à objectifs de projection microlithographique selon l'une des revendications 1 à 6, **caractérisé en ce que** les miroirs du second sous-système présentent des rayons R sensiblement identiques.

**8.** Dispositif à objectifs de projection microlithographique selon la revendication 7, **caractérisé en ce que** l'espacement des deux miroirs du second sous-système mesure environ $R/\sqrt{2}$.

**9.** Dispositif à objectifs de projection microlithographique selon l'une des revendications 2 à 8, **caractérisé en ce que** le premier sous-système occupe une position respectivement proche de l'objet ou du réticule.

**10.** Dispositif à objectifs de projection microlithographique selon la revendication 9, **caractérisé en ce que** des premier (S1) et troisième (S3) miroirs du premier sous-système présentent des rayons sensiblement identiques.

**11.** Dispositif à objectifs de projection microlithographique selon l'une des revendications 1 à 10, **caractérisé en ce que** le miroir le plus rapproché de l'objet à éclairer, et de préférence de la plaquette, est agencé de façon telle que

- la libre distance optique de travail, située côté image, corresponde au moins au diamètre utilisé D de ce miroir le plus proche de la plaquette, et/ou que
- la libre distance optique de travail, située côté image, représente au moins la somme d'un tiers du diamètre utilisé D de ce miroir, et d'une longueur comprise entre 20 mm et 30 mm, et/ou que
- la libre distance optique de travail, située côté image, mesure au moins 50 mm, de préférence 60 mm.

**12.** Dispositif à objectifs de projection microlithographique selon l'une des revendications 1 à 11, **caractérisé en ce que** l'ouverture numérique NA située côté image se trouve dans la plage

$$NA \geq 0{,}10$$

et la largeur W du champ annulaire, sur la plaquette, se situe dans la plage

$$W \geq 1{,}0 \, mm \, ;$$

et **en ce que** l'écart (A) de crête à crête des asphères, vis-à-vis de la sphère la mieux adaptée dans la plage utile sur tous les miroirs, est limité par

$$A \leq 24 \ \mu m - 129 \ \mu m \ (0,20 - NA) - 2,1 \ \frac{\mu m}{mm} \ (2 \ mm - W).$$

**13.** Dispositif à objectifs de projection microlithographique selon l'une des revendications 1 à 12, **caractérisé en ce que** les surfaces des miroirs sont situées sur des surfaces à symétrie de révolution par rapport à un axe principal (HA).

**14.** Dispositif à objectifs de projection microlithographique selon l'une des revendications 1 à 12, **caractérisé en ce que** le diaphragme (B) est placé sur le corps du premier miroir (S1), sur la trajectoire des rayons entre les deuxième (S2) et troisième (S3) miroirs.

**15.** Dispositif à objectifs de projection microlithographique selon la revendication 14, **caractérisé en ce que** le diaphragme est librement accessible entre les deuxième et troisième miroirs.

**16.** Dispositif à objectifs de projection microlithographique selon l'une des revendications 1 à 15, **caractérisé en ce que** l'ouverture numérique NA située côté image est $\geq 0,10$, et la largeur W du champ annulaire sur la plaquette est $\geq 1$ mm ; et **en ce que** l'écart (A) de crête à crête des asphères, vis-à-vis des sphères les mieux adaptées dans la plage utile sur tous les miroirs, est limité par

$$A \leq 9 \ \mu m - 50 \ \mu m \ (0,20 - NA) - 0,4 \ \frac{\mu m}{mm} \ (2 \ mm - W).$$

**17.** Dispositif à objectifs de projection microlithographique selon l'une des revendications 14 à 16, **caractérisé en ce qu'**au moins quatre miroirs sont asphériques.

**18.** Dispositif à objectifs de projection microlithographique selon la revendication 17, **caractérisé en ce que** tous les miroirs sont de réalisation asphérique.

**19.** Dispositif à objectifs de projection microlithographique selon l'une des revendications 1 à 18, **caractérisé en ce que** l'échelle de reproduction du premier sous-système, constitué des premier (S1), deuxième (S2) et troisième (S3) miroirs, est négative ou réductrice, de préférence $- 0,5 > \beta > - 1,0$.

**20.** Dispositif à objectifs de projection microlithographique selon l'une des revendications 1 à 19, **caractérisé en ce que** l'erreur de front d'ondes rms du système mesure au maximum $0,07 \ \lambda$, de préférence $0,03 \ \lambda$ sur la totalité du champ d'image.

**21.** Dispositif à objectifs de projection microlithographique selon la revendication 20, **caractérisé en ce que** le champ d'image présente une largeur d'au moins 1,0 mm.

**22.** Dispositif à objectifs de projection microlithographique selon l'une des revendications 1 à 21, **caractérisé en ce qu'**il est télécentrique côté image.

**23.** Dispositif à objectifs de projection microlithographique selon la revendication 22, **caractérisé en ce qu'**il est télécentrique côté objet.

**24.** Dispositif à objectifs de projection microlithographique selon l'une des revendications 1 à 22, **caractérisé en ce que** le rayon principal chemine, sur l'objet, en direction de l'axe optique.

**25.** Installation d'illumination par projection équipée d'un dispositif à objectifs de projection microlithographique selon l'une des revendications 1 à 24, **caractérisée en ce qu'**il est prévu un masque de réflexion.

**26.** Installation d'illumination par projection équipée d'un dispositif à objectifs de projection microlithographique selon l'une des revendications 1 à 24, **caractérisée en ce qu'**il est prévu un masque de transmission.

**27.** Installation d'illumination par projection selon l'une des revendications 25 à 26, **caractérisée en ce que** ladite installation d'illumination par projection englobe un dispositif d'éclairage en vue de l'éclairage d'un champ annulaire.

28. Procédé de fabrication de puces à l'aide d'une installation d'illumination par projection selon l'une des revendications 25 à 27.

*FIG.1*

EP 1 037 115 B1

EP 1 037 115 B1

# FIG. 2

*FIG. 3A*

*FIG.3B*